# EUROPEAN PATENT SPECIFICATION

(11) **EP 1 266 399 B1**
(45) Date of publication and mention of the grant of the patent: **29.08.2012**
(21) Application number: 01906698.4
(22) Date of filing: 25.01.2001
(51) Int. Cl.: H01L 21/301, H01L 21/44, H01L 23/02

(54) **THINNING AND DICING OF SEMICONDUCTOR WAFERS USING DRY ETCH, AND OBTAINING SEMICONDUCTOR CHIPS WITH ROUNDED BOTTOM EDGES AND CORNERS**
VERDÜNNEN UND AUFTEILEN VON HALBLEITERWAFERN DURCH TROCKENÄTZUNG UND ERHALTEN VON HALBLEITERCHIPS MIT GERUNDETEN UNTEREN RÄNDERN UND ECKEN
AMINCISSEMENT ET DECOUPE DE PLAQUETTES DE SEMICONDUCTEURS PAR ATTAQUE A SEC, ET OBTENTION DE PUCES DE SEMICONDUCTEURS A BORDS ET A COINS INFERIEURS ARRONDIS

(30) Priority: 26.01.2000 US 491456
(43) Date of publication of application: 18.12.2002
(73) Proprietor: ALLVIA, Inc., Sunnyvale, CA 94086 (US)
(72) Inventor: SINIAGUINE, Oleg, San Carlos, CA 94070 (US); HALAHAN, Patrick, San Mateo, CA 94403 (US); SAVASTIOUK, Sergey, San Jose, CA 95125 (US)
(74) Representative: Freeman, Jacqueline Carol
(86) International application number: PCT/US2001/002544
(87) International publication number: WO 2001/056063

(56) References cited:
- WO-A-01/03180
- WO-A-98/33215
- US-A- 3 739 463
- US-A- 3 991 296
- US-A- 6 004 867
- US-A1- 5 597 766
- US-A1- 5 693 182
- US-B1- 6 176 966
- SINIAGUINE O: "Plasma Jet Etching at Atmospheric Pressure for Semiconductor Production" 1ST INT. SYMP. ON PLASMA PROCESS-INDUCED DAMAGE, MAY 13-14, 1996, SANTA CLARA, USA, 13 May 1996 (1996-05-13), pages 151-153, XP010303296

## Description

### BACKGROUND OF THE INVENTION

The present invention relates to thinning and dicing of semiconductor wafers using a dry etch.

In many semiconductor fabrication processes, when circuitry has been fabricated in a semiconductor wafer, the wafer is thinned and then diced into chips. The thinning is typically performed with mechanical lapping. Dicing is performed with a diamond saw or a laser. The diamond saw or the laser can be used to cut the wafer all the way through along scribe lines. Alternatively, the wafer is cut part of the way through, and then broken.

The thinning and dicing processes can damage the wafer. It is desirable to provide alternative processes that reduce wafer damage and prolong the lifetime of chips obtained from the wafer.

WO-A-98/33215 discloses a packaging technique for electronic devices includes wafer fabrication of contacts on the bottom surface of the substrate underneath the active circuit. A trench is formed in the top surface of a substrate parallel to the edge of its electronic circuit. A gold wire extends from a connection point within the circuit into the trench. After epoxy encapsulating the top of the substrate, it is back thinned to expose the bottom surface of the gold wire. Either the back thinning is selective so as to form a substrate standoff, or an epoxy standoff is applied to the bottom of the substrate.

US-B-5597766 discloses a method for detaching chips in the silicon layer of a SOI substrate, wherein trenches are etched between the chips down to the insulating layer of the SOI substrate. Spacers for the passivation of Si02 layers of the chips are produced. Finally, the chips are detached by etching the insulating layer off.

US-B-5693182 discloses a method for making large scale integrated circuits on a disklike semiconductor substrate includes grinding a disk thin enough to be able to be sawn apart into individual chips. A damage zone caused by the grinding on a back side of the wafer is removed by etching while protecting a front side of the wafer, prior to sawing.

WO-A-01/03180 discloses a method of subdividing a wafer which comprises a plurality of individual circuit structures. A trench is defined between at least two circuit structures on one face of the wafer. A releasable intermediate support is fixed on the one face of the wafer. Said releasable intermediate support consists of a fixed intermediate support substrate and an adhesive medium that is applied on said intermediate support substrate and that can be specifically modified in terms of its adhesive strength. The wafer is then dry-etched from the opposite face so that circuit chips are obtained that are linked with one another only via the intermediate support. Said circuit chips are subsequently removed from the intermediate support.

### SUMMARY

According to the present invention there is provided a method for obtaining one or more chips from a semiconductor wafer, the method comprising: forming one or more openings in a first side of the semiconductor wafer along a boundary of the one or more chips, wherein the one or more openings do not go through the wafer; and thinning the wafer with a dry etch to remove material from a second side of the wafer at least until the one or more openings become exposed on the second side, wherein the dry etch rounds one or more edges and/or corners formed on the wafer's second side by a sidewall of each of the one or more openings when the sidewall becomes exposed on the second side.

Some embodiments of the present invention reduce or eliminate wafer damage and prolong the chip lifetime by dicing the wafer part of the way through and then thinning the wafer with a dry etch. The chip lifetime is prolonged because the dry etch removes damage from chip surfaces and rounds the chip's edges and corners.

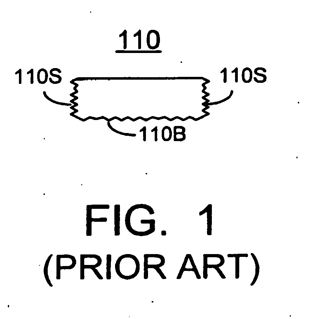

More particularly, as illustrated in Fig. 1, a chip110 obtained by prior art thinning and dicing techniques may have uneven, damaged surfaces 11OB, 110S, with sharp bottom corners and edges. Surface 11OB is the chip's backside, and surfaces 110S are sidewalls.

The wafer has been thinned from backside 11OB by mechanical lapping, and then diced along sidewalls 11OS with a diamond saw or a laser apparatus. These thinning and dicing processes damage the backside 11OB and sidewalls 110S. The damage may include chipped, jagged surfaces, and microcracks. When the chip 110 is later packaged and put into use, the chip is subjected to heating and cooling cycles. These cycles cause the chip's packaging material (not shown) to exert stresses on the chip. Additional stresses can be developed inside the chip due to the thermal cycles, chip handling, or the presence of different materials or other non-uniformities inside the chip. Because the chip surfaces 110B, 110S are damaged, and because they intersect at sharp edges and corners, the stresses concentrate at isolated points on the chip surface. Further, microcracks weaken the chip's resistance to stress. As a result, the chip becomes less reliable. Cracks formed or extended by stresses in the chip can reach and damage the chip circuitry (not shown).

Dry etch provides smoother chip surfaces and rounded edges and corners. Damage is reduced or eliminated. The chip reliability is therefore improved.

In some embodiments of the present invention, the wafer is processed as follows. The wafer is diced to form grooves in the face side of the wafer. The grooves are at least as deep as the final thickness of each chip to be obtained from the wafer. Dicing can be performed with a diamond saw or a laser. The grooves' sidewalls can be damaged.

Then the wafer is placed into a non-contact wafer holder, and the wafer backside is etched with the dry etch until the grooves are exposed from the backside. The dry etch leaves the chips' backside smooth. In some embodiments, the dry etch continues after the grooves have been exposed from the backside. The etchant gets into the grooves and smoothens the chip sidewalls, removing at least some of the sidewall damage. The etchant also rounds the bottom corners and edges of the chips.

Suitable etches include atmospheric pressure plasma etches described, for example, in the PCT Application PCT/US97/18979 (WO 98/19337) filed October 27,1997. These etches are fairly fast. Silicon can be etched at 10 µm/min.

In some embodiments, the dry etch is a blanket uniform etch of the wafer's flat backside surface. No masking layers are used on the backside surface.

The invention is not limited to the embodiments described above. In some embodiments, one or more openings are formed in a first surface of a semiconductor wafer along a boundary of one or more chips. The openings do not go through the wafer. The wafer is placed into a non-contact wafer holder and thinned with a dry etch until the openings are exposed on a second side.

Other features of the invention are described below. The invention is defined by the appended claims.

### BRIEF DESCRIPTION OF THE DRAWINGS

Fig. 1 is a side view of a prior art semiconductor chip.
Fig. 2A is a top view of a wafer being processed according to an embodiment of the present invention.
Fig. 2B shows a cross-section of the wafer of Fig. 2A along the lines II - II.
Figs. 3 and 4 are cross-sections illustration of a wafer and processing equipment during wafer thinning according to an embodiment of the present invention.
Fig. 5 is a perspective view of a chip processed according to an embodiment of the present invention.
Fig. 6 is a side view of a packaged chip processed according to an embodiment of the present invention.
Figs. 7 through 11 are cross-section illustrations of wafers being processed according to embodiments of the present invention.

### DESCRIPTION OF SOME EMBODIMENTS

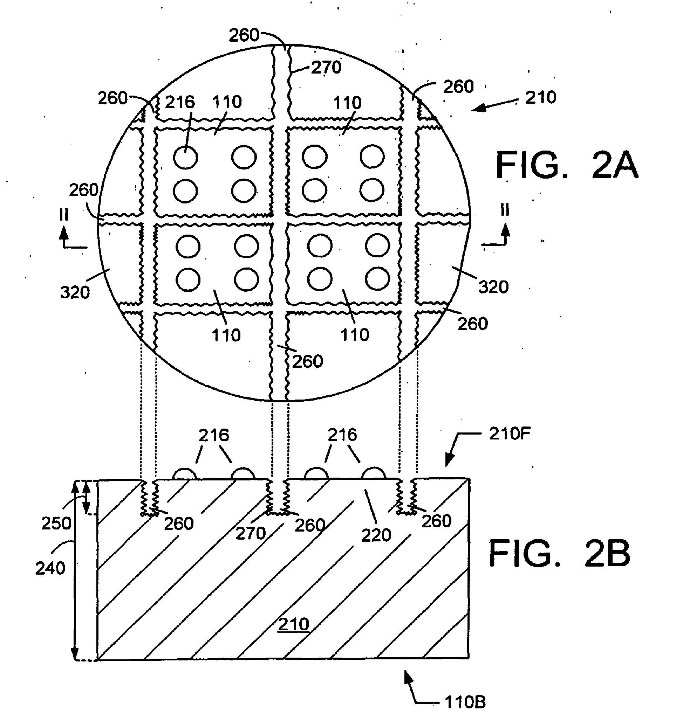

Fig. 2A is a top view of a semiconductor wafer 210 shown before the wafer is thinned with a dry etch. Fig. 2B is a cross sectional view of the wafer along the lines II-II in Fig. 2A. Circuitry has been fabricated in the wafer, and the wafer must now be divided into chips 110. The circuitry may include transistors, diodes, and other devices (not shown) manufactured in and over an active layer 220 (Fig. 2B) adjacent to the wafer top surface 210F (the surface shown in Fig. 2A). Optional conductive bumps 216 have been manufactured on contact pads on top surface 210F of chips 110. The bumps will be used to connect the chips to wiring substrates (not shown), e. g., printed circuit boards.

The wafer thickness 240 has been sufficiently large to achieve suitable mechanical strength and heat dissipation during fabrication of the wafer circuitry. 720 µm is suitable for some silicon wafer fabrication processes. The wafer will now be thinned to its final thickness 250. In some embodiments, the final thickness is 10-450 µm. These thickness figures are illustrative and not limiting.

After the circuitry and the bumps 216 were manufactured, grooves 260 were formed in the wafer top surface along scribe lines and, in particular, along the boundary of chips 110. The grooves could be formed by conventional dicing techniques, e. g. with a diamond saw or a laser. Other processes, e. g., a masked etch, could also be used. The grooves do not go through the wafer. The grooves are at least as deep as the final chip thickness 250. In some embodiments, the groove depth is 10-450 µm. The grooves will be exposed from the bottom during wafer thinning when the wafer back side 110B is etched, as described below.

The groove sidewall and bottom surfaces 270 can be damaged by dicing, as schematically shown by uneven lines in Figs. 2A, 2B.

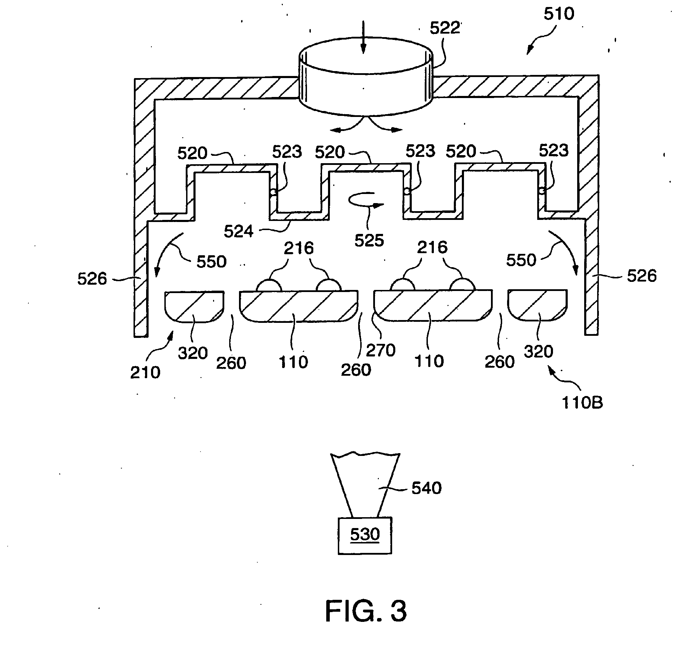

Wafer 210 is placed in a non-contact wafer holder 510 (Fig. 3). Holder 510 includes one or more vortex chucks 520 having outlets in the holder's surface 524. Surface 524 faces the top surface of the wafer. Gas supplied under pressure through a conduit 522 enter chucks 520 through respective passages 523. Each passage is tangential to the chuck's cylindrical chamber when viewed from the top. A gas vortex 525 emitted by each chuck towards the wafer generates a low pressure zone near the chuck's vertical axis. In this zone, the wafer is drawn towards the chuck. At the same time, the gas vortices do not allow the wafer to touch the holder surface 524. Such wafer holders are described, for example, in U. S. patent application no. 09/456,135 "Non-Contact Workpiece Holder" filed by O. Siniaguine et al. on December 7,1999. Other suitable holders are described in PCT publication WO 99/46805 (TruSi Technologies, LLC, September 16,1999). Other holders, for example, Bernoulli type holders, can also be used.

Wafer holder 510 is called "non-contact" because the top surface of the wafer does not contact the holder surface 524. However, the edge of the wafer can contact the holder's limitors 526 which extend around the wafer to restrict the wafer lateral motion. In some embodiments, holder 510 is mounted on a rotating carousel (not shown). The carousel rotation develops a centrifugal force that presses the wafer against one or more limitors 526. See PCT publication WO 99/26796 (TruSi Technologies, LLC, June 3, 1999).

The wafer backside surface 110B is etched with a dry etch. In Fig. 3, the etch is a blanket (unmasked) uniform etch of the wafer's flat semiconductor backside surface (e.g., silicon surface). The etch is atmospheric pressure plasma etch. Plasma generator 530 generates plasma 540 into which suitable reagents are injected. If the wafer is made of silicon, a CF4 etch can be used. See PCT publication WO 98/19337 (TruSi Technologies, LLC, May 7, 1998). A suitable etcher is type Tru-Etch 3000 (trademark) available from TruSi Technologies, LLC, of Sunnyvale, California. The dry etch thins the wafer until the grooves 260 are exposed from the bottom. When the grooves are exposed, the plasma enters the grooves and etches the groove sidewalls 270. The sidewalls become smoother as a result. The dicing damage becomes partially or completely removed from the sidewalls. The bottom corners and edges of chips 110 become rounded.

Advantageously, some atmospheric pressure plasma etching processes described in WO 98/19337 are fast. Silicon can be etched at the rate of about 10 µm/min. Other kinds of etches can also be used. The dry etch can be preceded by mechanical lapping of the wafer bottom surface 110B.

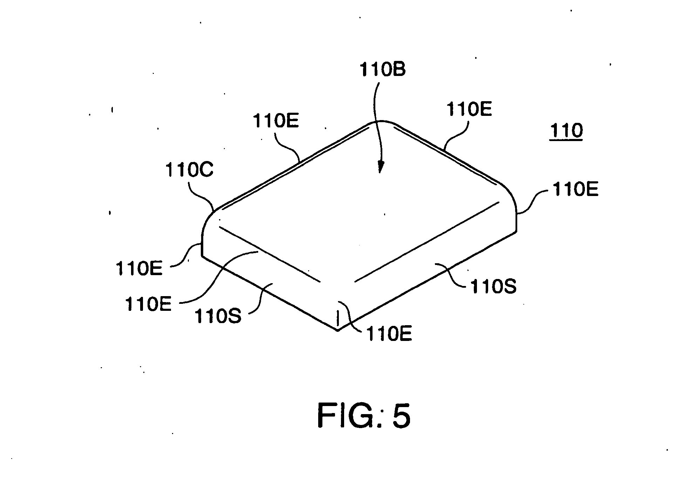

In some embodiments, before the backside etch, the groove depth 250 (Fig. 2) exceeds the final chip thickness by an amount needed to obtain the rounded edges and corners and smooth sidewalls for chips 110. The more the groove depth exceeds the final chip thickness, the longer the duration of the backside etch after the grooves have been exposed from the bottom. The bottom corners and edges become more rounded, and more time is allowed for sidewall damage removal. In some embodiments, the radius of the rounded corners is roughly 1.5 times the thickness of the material removed from the wafer backside after the grooves are exposed. The depth of the grooves also takes into account possible wafer non-uniformity, the non-uniformity of the dicing process that creates the grooves, and the non-uniformity of the backside etch. If mechanical lapping or any other process is used to remove material from the wafer backside before the dry etch illustrated in Fig. 5, the non-uniformity of such process can also be taken into account. In some embodiments, the groove depth 250 exceeds the final chip thickness by 10 µm or more.

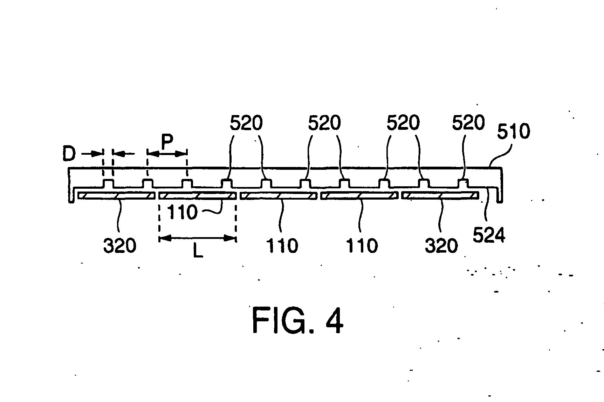

When the grooves 260 become exposed during the thinning etch of Fig. 3, chips 110 become separated from each other, but the chips are held in holder 510 by the vacuum forces developed by the gas vortices. The vortex chucks 520 are positioned close to each other to insure that each chip 110 will be adjacent to a low pressure zone developed by at least one chuck 520. In Fig. 4, "L" denotes the greatest lateral dimension of each chip 110. "P" is the distance between the centers of the adjacent chucks 520. "D" is the diameter of each chuck. "P" and "D" can vary for different chucks 520 in the same wafer holder. The diameter D of each vortex chuck should be small enough to prevent a chip from being sucked into the chuck. The chip should be balanced at a predetermined distance from the wafer holder surface 524 by the vacuum forces drawing the chip towards the holder and the opposite-direction forces generated between the chucks by the gas flowing away from the chucks. In some embodiments, D < L/2 and P < L/2 for all the chucks.

In some embodiments, each ofP and D is less than one half of the shortest side of each rectangular chip 110.

In some embodiments, the distance between the adjacent chucks and the diameter of each chuck take into account the peripheral wafer portions 320 (Fig. 2A). Each of P and D is less than one half of the greatest lateral dimension, or of the longest or shortest side, of each portion 320.

Fig. 5 is a perspective view of a chip 110 after the etch. The chip is shown bottom side up. The chip's sidewalls 110S and bottom surface 110B are smooth. The edges 110E at which the sidewalls 110S meet with each other and with the bottom surface 110B are rounded, and so are the bottom corners 110C. The smooth surfaces and the rounded edges and corners prolong the chip's lifetime and improve the chip's reliability.

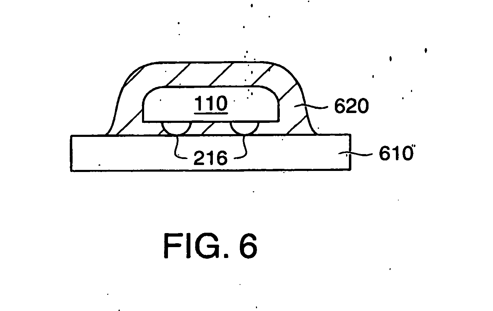

In Fig. 6, chip 110 has been mounted on a printed circuit board 610 using flip chip technology. Bumps 216 are soldered to the printed circuit board. Encapsulant 620 (suitable plastic) is deposited over the chip for protective purposes. The chip's smooth surfaces and rounded edges and corners prolong the chip's lifetime. Similar advantages are achieved with non-flip-chip packaging.

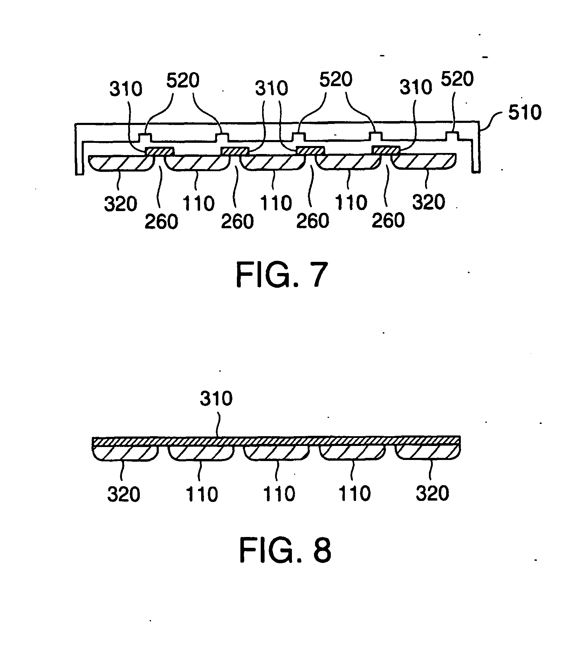

In Fig. 7, the etch uniformity is improved by depositing a layer 310 over grooves 260 and wafer portions adjacent to the grooves. Layer 310 is deposited before the backside etch of the wafer. When chips 110 and peripheral portions 320 become separated during the backside etch, the layer 310 holds the chips and the portions 320 in the same position relative to each other. Therefore, the gaps between the chips 110 and the peripheral portions 320 remain uniform, and hence the chip sidewalls (the sidewalls of grooves 260) are etched uniformly. If some chips 110 were too close to each other or to peripheral portions 320, the chips' sidewalls could be etched too slowly, and less, damage would be removed than desirable. Other sidewalls; farther from adjacent chips 110 or portions 320, cold be undesirably overetched.

Layer 310 also relaxes the requirements for the distance between adjacent vortex chucks 520 and the diameter of each chuck since the chips 110 and peripheral portions 320 are held in position by layer 310 throughout the backside etch.

Layer 310 can be a sticky material which adheres to the wafer without additional adhesive. Alternatively, adhesives can be used. In some embodiments, layer 310 is polyimide. Polyimide is chosen because it does not react with etchants utilized in some thinning processes (e.g., CF4). The thickness of polyimide layer 310 is 1 µm to 200 µm in some embodiments. Other materials and thicknesses can also be used. In some embodiments, layer 310 is an adhesive tape such as described in US patent 5,888,883 issued on March 30, 1999 to Sasaki et al.

Layer 310 does not cover the middle portions of chips 110, including the bumps 216. The bumps, and any other uneven features of the chip top surface 210F, are believed to be capable of impeding adhesion of layer 310 to the wafer.

In some embodiments, layer 310 is pre-manufactured as a continuous sheet. Then openings are cut out in layer 310 at the location of the middle portions of chips 110. Then layer 310 is deposited.

Layer 310 can be deposited using known techniques. In some embodiments, layer 310 is deposited at atmospheric pressure using a roller to remove air bubbles. Alternatively, layer 310 can be laminated on the wafer in vacuum, with or without a roller.

In some embodiments, layer 310 covers peripheral portions 320. In Fig. 8, layer 310 covers the entire wafer. In some embodiments, the top surface of chips 110 is even, bumps 216 are absent.

The invention is not limited to layer 310 covering or exposing any particular features of the wafer.

Layer 310 prevents the plasma from going through the grooves 260 and damaging the circuitry at the top surface of the wafer. Gas emitted by chucks 520 flows down around the wafer as shown at 550 in Fig. 3, and impedes the plasma from flowing up around the wafer and reaching the wafer top surface. As indicated in the aforementioned U.S. patent application 09/456,135, the chuck density can be made high at the edge of wafer holder 510 to prevent the plasma from flowing up around the wafer. Gas can be made to flow down at all points around the wafer.

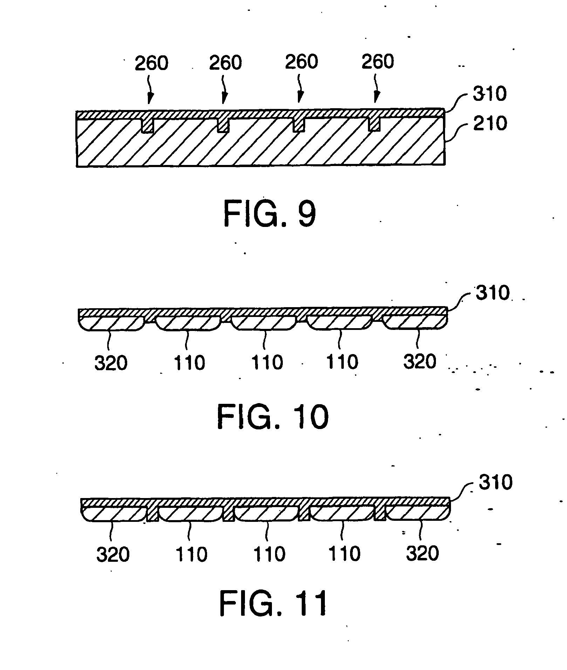

In Fig. 9, layer 310 has been deposited by a spin-on or spraying technique. Layer 310 fills grooves 260. (In contrast, in Figs. 7 and 8, the grooves are not filled.) Layer 310 in Fig. 9 can be polymer or some other material.

Fig. 10 shows the structure after the backside etch for Fig. 9. In the embodiment of Fig. 10, when layer 310 is exposed from the bottom, layer 310 is etched faster than the wafer substrate. Therefore, the bottom surface of layer 310 is higher than the bottom surface of chips 110 and peripheral portions 320. The bottom corners and edges of chips 110 have been exposed to the etchant, and have been rounded.

Fig. 11 illustrates an embodiment in which the layer 310 is etched slower than the wafer substrate. This is the case if layer 310 is polyimide, the wafer is a silicon wafer, and the etch is a CF4 plasma etch. Layer 310 is etched slowly, but the microloading effect causes the chips 110 to be etched faster at the bottom edges adjacent to layer 310. As a result, the bottom edges and corners of chips 110 are rounded.

After the etch of Fig. 10 or 11, layer 310 is removed. In some embodiments, polyimide layer 310 is removed by oxygen plasma.

The above embodiments illustrate but do not limit the invention. The invention is not limited to silicon wafers or any packaging technology. The invention is not limited to plasma etching, or to any particular etch chemistry or type of etcher. The invention is not limited to wafers containing multiple chips. In some embodiments, only one chip has been fabricated in the wafer. The chip is extracted and the wafer peripheral portions 320 are discarded. The invention is not limited to unmasked or uniform backside etches.

## Claims

1. A method for obtaining one or more chips from a semiconductor wafer, the method comprising:
forming one or more openings (260) in a first side of the semiconductor wafer along a boundary of the one or more chips (110), wherein the one or more openings do not go through the wafer and comprise a groove extending along the entire boundary of at least one chip; and
thinning the wafer with a dry etch to remove material from a second side (110B) of the wafer, wherein during the dry etch the one or more openings become exposed on the second side, and after the one or more openings become so exposed, the dry etchant enters the one or more openings to etch at least one sidewall (270) of each of the one or more openings, and the dry etch simultaneously etches (i) the one or more openings' extremity on the second side and (ii) the at least one sidewall (270) of each of the one or more openings in a region positioned between the first side and the sidewall's extremity on the second side, and the simultaneous etch rounds one or more of the edges and corners formed on the wafer's second side by the sidewalls (270) of the one or more openings;
wherein the thinning operation comprises placing the wafer into a wafer holder (510) for the dry etch, the wafer not contacting the wafer holder's surface facing the wafer's first side (524).

2. The method of any preceding claim wherein the wafer holder comprises one or more vortex chucks (520) each of which emits a gas vortex towards the wafer to hold the wafer in the holder.

3. The method of any preceding claim wherein the method further comprises forming a protective layer (310) overlying the openings, the protective layer protecting the first side of the wafer during the dry etch from an etchant penetrating through the openings from the second side and damaging the first side when the openings become exposed on the second side.

4. The method of claim 3 wherein the protective layer does not cover the entire first side of the wafer.

5. The method of claim 3 wherein the protective layer covers the entire first side of the wafer.

6. The method of any preceding claim wherein the dry etch comprises an atmospheric pressure plasma etch.

7. The method of any preceding claim wherein after the grove is exposed from the second side, the dry etch continues and smoothens the groove's sidewall.

8. The method of any preceding claim wherein the semiconductor wafer comprises circuitry made at the first side of the wafer, the second side is a backside opposite to the first side, and at least part of the groove is formed along a scribe line on the first side.

9. The method of any preceding claim wherein the groove is formed with a diamond saw or a laser.

10. The method of any preceding claim wherein the wafer is made of silicon.

11. The method of any preceding claim wherein the dry etch rounds all of the edges and corners on the second side of each semiconductor chip obtained from the wafer in the dry etch.

12. The method of any preceding claim wherein from a start of the thinning operation until the groove is exposed, the dry etch etches the second side of the wafer uniformly.

13. The method of any preceding claim wherein the entire dry etch is an unmasked etch of the second side.

14. The method of any preceding claim wherein the depth (250) of the one or more openings (260) before the dry etch exceeds the wafer thickness after the dry etch by 10µm or more.

## Patentansprüche

1. Verfahren zum Gewinnen von einem oder mehreren Chips von einem Halbleiterwafer, wobei das Verfahren Folgendes beinhaltet:
Ausbilden von einer oder mehreren Öffnungen (260) in einer ersten Seite des Halbleiterwafers entlang einer Begrenzung der ein oder mehreren Chips (110), wobei die ein oder mehreren Öffnungen nicht durch den Wafer gehen und eine Rille beinhalten, die entlang der gesamten Begrenzung von wenigstens einem Chip verläuft; und
Verdünnen des Wafers durch Trockenätzen zum Entfernen von Material von einer zweiten Seite (110B) des Wafers, wobei während des Trockenätzens die eine oder mehreren Öffnungen auf der zweiten Seite exponiert werden, und nachdem die eine oder mehreren Öffnungen so exponiert worden sind, das Trockenätzmittel in die ein oder mehreren Öffnungen eindringt, um wenigstens eine Seitenwand (270) von jeder der ein oder mehreren Öffnungen zu ätzen, und beim Trockenätzen gleichzeitig (i) das Ende der ein oder mehreren Öffnungen auf der zweiten Seite und (ii) die wenigstens eine Seitenwand (270) von jeder der ein oder mehreren Öffnungen in einer Region zwischen der ersten Seite und dem Ende der Seitenwand auf der zweiten Seite geätzt werden, und beim Ätzen gleichzeitig eine oder mehrere der Kanten und Ecken abgerundet werden, die auf der zweiten Seite des Wafers durch die Seitenwände (270) der ein oder mehreren Öffnungen gebildet werden;
wobei der Verdünnungsvorgang das Platzieren des Wafers in einem Waferhalter (510) zum Trockenätzen beinhaltet, wobei der Wafer nicht mit der der ersten Waferseite (524) zugewandten Waferhalterfläche in Kontakt kommt.

2. Verfahren nach dem vorherigen Anspruch, wobei der Waferhalter ein oder mehrere Wirbel-Aufspannvorrichtungen (520) umfasst, die jeweils einen Gaswirbel in Richtung auf den Wafer emittieren, um den Wafer im Halter zu halten.

3. Verfahren nach einem der vorherigen Ansprüche, wobei das Verfahren ferner das Ausbilden einer über den Öffnungen liegenden Schutzschicht (310) beinhaltet, wobei die Schutzschicht die erste Seite des Wafers während des Trockenätzens vor Ätzmittel schützt, das durch die Öffnungen von der zweiten Seite dringt und die erste Seite beschädigt, wenn die Öffnungen auf der zweiten Seite exponiert werden.

4. Verfahren nach Anspruch 3, wobei die Schutzschicht nicht die gesamte erste Seite des Wafers bedeckt.

5. Verfahren nach Anspruch 3, wobei die Schutzschicht die gesamte erste Seite des Wafers bedeckt.

6. Verfahren nach einem der vorherigen Ansprüche, wobei das Trockenätzen eine Plasmaätzung auf atmosphärischem Druck beinhaltet.

7. Verfahren nach einem der vorherigen Ansprüche, wobei das Trockenätzen nach dem Exponieren der Rille von der zweiten Seite fortgesetzt wird und die Seitenwand der Rille glättet.

8. Verfahren nach einem der vorherigen Ansprüche, wobei der Halbleiterwafer Schaltungen aufweist, die auf der ersten Seite des Wafers ausgebildet sind, die zweite Seite eine Rückseite gegenüber der ersten Seite ist, und wenigstens ein Teil der Rille entlang einer Markierungslinie auf der ersten Seite ausgebildet ist.

9. Verfahren nach einem der vorherigen Ansprüche, wobei die Rille mit einer Diamantsäge oder einem Laser ausgebildet wird.

10. Verfahren nach einem der vorherigen Ansprüche, wobei der Wafer aus Silicium besteht.

11. Verfahren nach einem der vorherigen Ansprüche, wobei beim Trockenätzen alle Kanten und Ecken auf der zweiten Seite jedes Halbleiterchips abgerundet werden, der bei der Trockenätzung von dem Wafer gewonnen wird.

12. Verfahren nach einem der vorherigen Ansprüche, wobei vom Beginn des Verdünnungsvorgangs bis zum Exponieren der Rille die zweite Seite des Wafers beim Trockenätzen gleichförmig geätzt wird.

13. Verfahren nach einem der vorherigen Ansprüche, wobei die gesamte Trockenätzung eine unmaskierte Ätzung der zweiten Seite ist.

14. Verfahren nach einem der vorherigen Ansprüche, wobei die Tiefe (250) der ein oder mehreren Öffnungen (260) vor dem Trockenätzen die Waferdicke nach dem Trockenätzen um 10 µm oder mehr übersteigt.

## Revendications

1. Procédé d'obtention d'une ou plusieurs puces à partir d'une tranche semi-conductrice, le procédé comprenant :
la formation d'une ou plusieurs ouvertures (260) dans un premier côté de la tranche semi-conductrice le long d'une limite des une ou plusieurs puces (110), les une ou plusieurs ouvertures ne traversant pas la tranche et comprenant une rainure qui s'étend le long de toute la limite d'au moins une puce ; et
l'amincissement de la tranche par gravure sèche afin d'éliminer de la matière sur un second côté (110B) de la tranche, dans lequel durant la gravure sèche, les une ou plusieurs ouvertures deviennent exposées sur le second côté, et après cette exposition des une ou plusieurs ouvertures, l'agent de gravure sèche entre dans les une ou plusieurs ouvertures afin de graver au moins une paroi latérale (270) de chacune des une ou plusieurs ouvertures, et la gravure sèche grave simultanément (i) l'extrémité des une ou plusieurs ouvertures sur le second côté et (ii) l'au moins une paroi latérale (270) de chacune des une ou plusieurs ouvertures dans une région positionnée entre le premier côté et l'extrémité de la paroi latérale sur le second côté, et la gravure simultanée arrondit un ou plusieurs des bords et coins formés sur le second côté de la tranche par les parois latérales (270) des une ou plusieurs ouvertures ;
dans lequel l'opération d'amincissement comprend le placement de la tranche dans un support de tranche (510) en vue de la gravure sèche, la tranche ne faisant pas contact avec la surface du support de tranche faisant face au premier côté (524) de la tranche.

2. Procédé selon l'une quelconque des revendications précédentes, dans lequel le support de tranche comprend un ou plusieurs plateaux de maintien de tranche à tourbillons (520) lesquels émettent chacun un tourbillon de gaz vers la tranche afin de maintenir la tranche dans le support.

3. Procédé selon l'une quelconque des revendications précédentes, comprenant en outre la formation d'une couche de protection (310) qui recouvre les ouvertures, la couche de protection protégeant le premier côté de la tranche durant la gravure sèche par rapport à un agent de gravure qui pénètre par les ouvertures sur le second côté et endommage le premier côté quand les ouvertures deviennent exposées sur le second côté.

4. Procédé selon la revendication 3, dans lequel la couche de protection ne couvre pas tout le premier côté de la tranche.

5. Procédé selon la revendication 3, dans lequel la couche de protection couvre tout le premier côté de la tranche.

6. Procédé selon l'une quelconque des revendications précédentes, dans lequel la gravure sèche comprend une gravure par plasma sous pression atmosphérique.

7. Procédé selon l'une quelconque des revendications précédentes, dans lequel après que la rainure est exposée sur le second côté, la gravure sèche continue et lisse la paroi latérale de la rainure.

8. Procédé selon l'une quelconque des revendications précédentes, dans lequel la tranche à semi-conducteur comprend des circuits réalisés sur un premier côté de la tranche, le second côté est un envers opposé au premier côté, et au moins une partie de la rainure est formée le long d'un chemin de découpe sur le premier côté.

9. Procédé selon l'une quelconque des revendications précédentes, dans lequel la rainure est formée avec une scie à diamant ou un laser.

10. Procédé selon l'une quelconque des revendications précédentes, dans lequel la tranche est réalisée en silicium.

11. Procédé selon l'une quelconque des revendications précédentes, dans lequel la gravure sèche arrondit tous les bords et coins sur le second côté de chaque puce semi-conductrice obtenue à partir de la tranche dans la gravure sèche.

12. Procédé selon l'une quelconque des revendications précédentes, dans lequel depuis le début de l'opération d'amincissement jusqu'à l'exposition de la rainure, la gravure sèche grave le second côté de la tranche uniformément.

13. Procédé selon l'une quelconque des revendications précédentes, dans lequel la totalité de la gravure sèche est une gravure non masquée du second côté.

14. Procédé selon l'une quelconque des revendications précédentes, dans lequel la profondeur (250) des une ou plusieurs ouvertures (260) avant la gravure sèche dépasse l'épaisseur de la tranche après la gravure sèche de 10 µm ou plus.
